# EUROPÄISCHE PATENTANMELDUNG

(11) **EP 3 059 511 A1**
(43) Veröffentlichungstag der Anmeldung: **24.08.2016**
(21) Anmeldenummer: 15202809.8
(22) Anmeldetag: 28.12.2015
(51) Int. Cl.: F24F 5/00, F24F 7/00, F24F 12/00, H05K 7/20

(54) **RAUMLUFTTECHNISCHES GERÄT SOWIE VERFAHREN ZUM KÜHLEN EINES RECHENZENTRUMS**

(30) Priorität: 17.02.2015 DE 102015001845
(71) Anmelder: Howatherm Klimatechnik GmbH, 55767 Brücken (DE)
(72) Erfinder: Dr. Kaup, Christoph, 55767 Brücken (DE)
(74) Vertreter: Westphal, Mussgnug & Partner Patentanwälte mbB

(57) **Zusammenfassung**

Die Erfindung betrifft ein raumlufttechnisches Gerät, insbesondere für die Kühlung eines Rechenzentrums (10), mit zumindest einem Abluft- (12), zumindest einem Zuluft- (14), zumindest einem Fortluft- (16.1, 16.2) und zumindest einem Außenluftanschluss (18.1, 18.2), mit einem ersten Hauptströmungsweg (17) zwischen dem zumindest einen Außenluftanschluss (18.1) und dem zumindest einen Zuluftanschluss (14) und einem zweiten Hauptströmungsweg (15) zwischen dem zumindest einen Abluftanschluss (12) und dem zumindest einen Fortluftanschluss (16.1, 16.2) und mit einem Kühlmodul (22), wobei in dem ersten (17) und dem zweiten Hauptströmungsweg (15) je ein Ventilator (15.V, 17.V) vorgesehen ist.

Die Erfindung betrifft ferner ein Verfahren zur Kühlung eines Rechenzentrums (10).

Erfindungsgemäß sind zumindest ein zweiter Außenluftanschluss (18.2), zumindest ein zweiter Fortluftanschluss (16.2) und zumindest ein dritter Hauptströmungsweg (13) mit einem dritten Ventilator (13.V) vorgesehen, wobei zumindest zwei Hauptströmungswege (13, 15, 17) im Gegenstrom durch zumindest eine Wärmerückgewinnung (20) geleitet sind.

## Beschreibung

Die Erfindung betrifft ein raumlufttechnische Gerät und ein Verfahren zum Kühlen eines Rechenzentrums, mit zumindest einem Abluft-, zumindest einem Zuluft-, zumindest einem Fortluft- und zumindest einem Außenluftanschluss, mit einem ersten Hauptströmungsweg zwischen dem zumindest einen Außenluftanschluss und dem zumindest einen Zuluftanschluss und einem zweiten Hauptströmungsweg zwischen dem zumindest einen Abluftanschluss und dem zumindest einen Fortluftanschluss und mit einem Kühlmodul, wobei in dem ersten und dem zweiten Hauptströmungsweg je ein Ventilator vorgesehen ist, gemäß den Oberbegriffen der Ansprüche 1 beziehungsweise 5.

Raumlufttechnische Geräte und solche Verfahren können beispielsweise DE 10 2011 054 257 A1, EP 2 199 699 A2 oder CA 2 428 409 A1 entnommen werden.

Je nach Luftfeuchte- und -temperaturverhältnissen erscheinen bekannte Systeme immer noch zu unflexibel bzw. für nachfolgend beschriebene Lösungswege ungeeignet.

Der vorliegenden Erfindung liegt die Aufgabe zugrunde, ein kostengünstig betreibbares raumlufttechnisches Gerät oder Kühlverfahren zu entwickeln, das eine flexiblere Luftbehandlung nach wechselnden Erforderlichkeiten wegen Veränderungen der Außenluftverhältnisse gestattet.

Diese Aufgabe wird mittels eines raumlufttechnischen Geräts und eines Verfahrens aufweisend die kennzeichnenden Merkmale des Anspruchs 1 beziehungsweise des Anspruchs 5 in Verbindung mit den jeweiligen Oberbegriffsmerkmalen gelöst.

Weitere vorteilhafte Ausgestaltungen der Erfindung bilden die Gegenstände weiterer Ansprüche.

Erfindungsgemäß sind zumindest ein zweiter Außenluftanschluss, zumindest ein zweiter Fortluftanschluss und zumindest ein dritter Hauptströmungsweg mit einem dritten Ventilator vorgesehen, wobei zumindest zwei Hauptströmungswege im Gegenstrom durch zumindest eine Wärmerückgewinnung geleitet sind.

Gemäß dem erfindungsgemäßen Verfahren werden zumindest zwei der drei Hauptströmungswege im Gegenstrom durch die Wärmerückgewinnung geleitet. Zumindest der dritte Hauptströmungsweg betreibt dabei mit dem dritten Ventilator die Wärmerückgewinnung mit der Zufuhr von Außenluft und / oder Abluft.

Als Erfolg der erfindungsgemäßen Lösung kann jedes beliebige System der Wärmerückgewinnung genutzt werden, beispielsweise ein Plattenwärmeübertrager. Es wird kein Kreislaufverbundsystem benötigt, weil die Wärmerückgewinnung gemäß der Erfindung nicht örtlich verteilt, beispielsweise entweder in einem Umluftströmungsweg oder in einem Bypass-Strömungsweg, angeordnet sein muss. Konnte bei solchen bekannten raumlufttechnischen Geräten bisher eine als Rückkühler betriebene Wärmerückgewinnung im Fortluftstrom nicht unabhängig von der Außenluft und/oder der Abluft betrieben werden, da sich bei bekannten raumlufttechnischen Geräten bei einem geforderten Mindestaußenluftanteil zwingend ein Mischpunkt aus beiden Luftvolumenströmen vor der Wärmerückgewinnung einstellt, gelingt das bei erfindungsgemäßer Verfahrensweise eben doch. Daher bleibt nun eine bisherige Konzentration auf den Mischpunkt vor der Fortluft-Wärmerückgewinnung nicht als einzige Möglichkeit für den Fall, dass ein Mindestaußenluftanteil zum Erreichen energetisch optimaler Bedingungen gefahren werden muss.

Die flexiblere Schaltung gemäß der Erfindung ergibt ein gesteigertes Kühlpotenzial, weil der Rückkühler unabhängig von dem Abluftstrom genutzt werden kann. Erfindungsgemäß kann entweder die Abluft durch die Wärmerückgewinnung geführt werden oder die Außenluft oder eine Mischung aus beiden Luftströmen.

Gemäß einer vorteilhaften Ausführungsform des Verfahrens wird ein Umluftanteil zunächst in Richtung des ersten Strömungswegs Richtung Außenluftanschluss geführt und nach Mischung mit Außenluft mit derselben durch die Wärmerückgewinnung geleitet, sodass die Eintrittsfeuchte vor der Luftbehandlung etwa 11 g/kg nicht überschreitet.

Dieses Beispiel aus einem der Unteransprüche ist eine der erfindungsgemäßen Verfahrensvarianten, welche die gewonnene Flexibilität verdeutlichen, wenn die erfindungsgemäßen raumlufttechnischen Geräte sich erfindungsgemäß in Abhängigkeit der Messung von absoluter Feuchte x in g/kg und Temperatur der Außenluft regeln lassen.

Zur Verdeutlichung der Erfindung sind in den nachfolgend beschriebenen Figuren Ausführungsbeispiele angegeben. Es zeigen:
- Fig. 1: ein erstes Ausführungsbeispiel eines erfindungsgemäßen raumlufttechnischen Geräts mit zwei Außenluftventilatoren und einem Abluftventilator in schematischer Darstellung,
- Fig. 2: ein zweites Ausführungsbeispiel eines erfindungsgemäßen raumlufttechnischen Geräts mit zwei Fortluftventilatoren und einem Zuluftventilator in schematischer Darstellung,
- Fig. 3: ein drittes Ausführungsbeispiel eines erfindungsgemäßen raumlufttechnischen Geräts mit einem Außenluftventilator, einem Fortluftventilator und einem Abluftventilator in schematischer Darstellung,
- Fig. 4: ein viertes Ausführungsbeispiel eines erfindungsgemäßen raumlufttechnischen Geräts mit einem Zuluftventilator, einem Fortluftventilator und einem Abluftventilator in schematischer Darstellung,
- Fig. 5: ein erstes Mollier-h-x-Diagramm für feuchte Luft,
- Fig. 6: ein alternativ zum ersten Mollier-h-x-Diagramm der Fig. 5, in das ein alternativer Winterfall dargestellt ist,
- Fig. 7: ein drittes Mollier-h-x-Diagramm für feuchte Luft,
- Fig. 8: ein viertes Mollier-h-x-Diagramm für feuchte Luft,
- Fig. 9: ein fünftes Mollier-h-x-Diagramm für feuchte Luft und
- Fig. 10: ein sechstes Mollier-h-x-Diagramm für feuchte Luft.

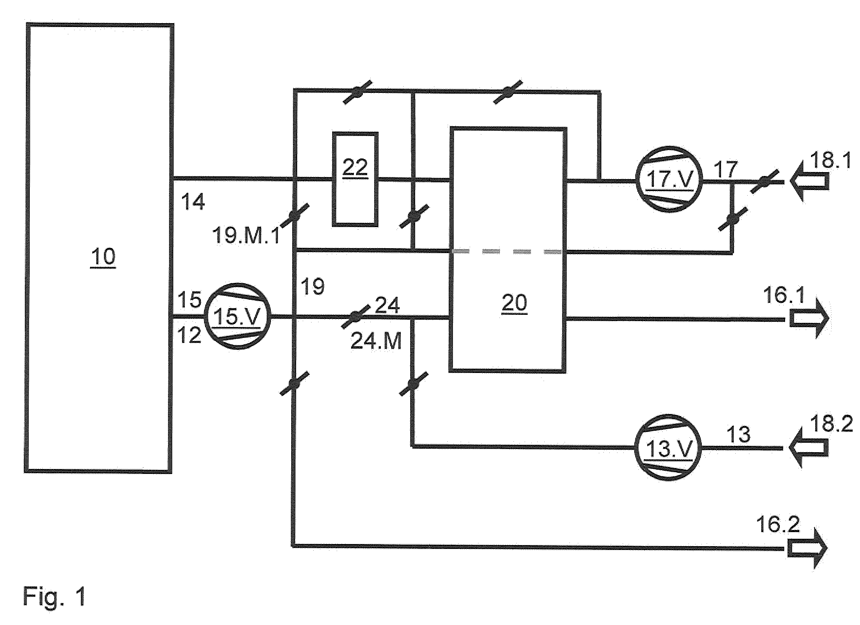

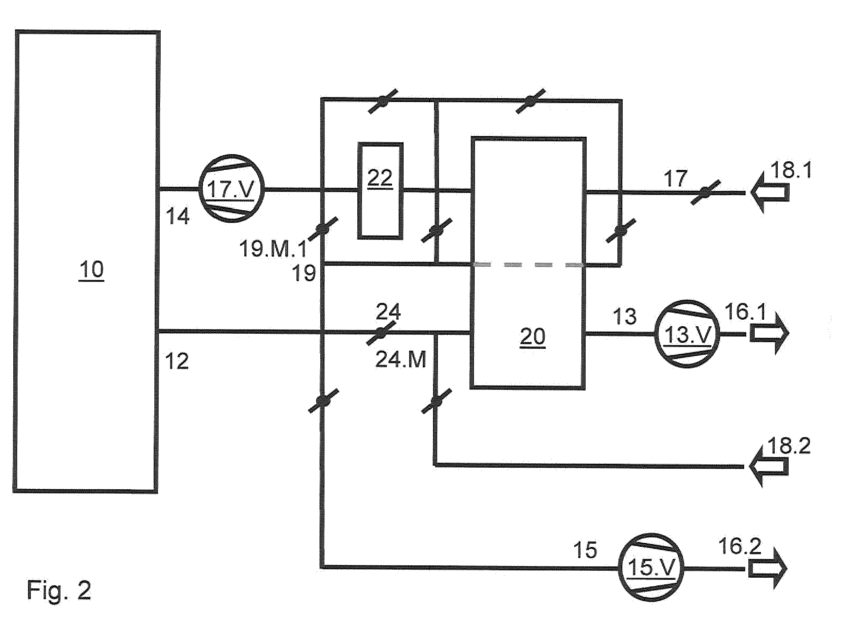

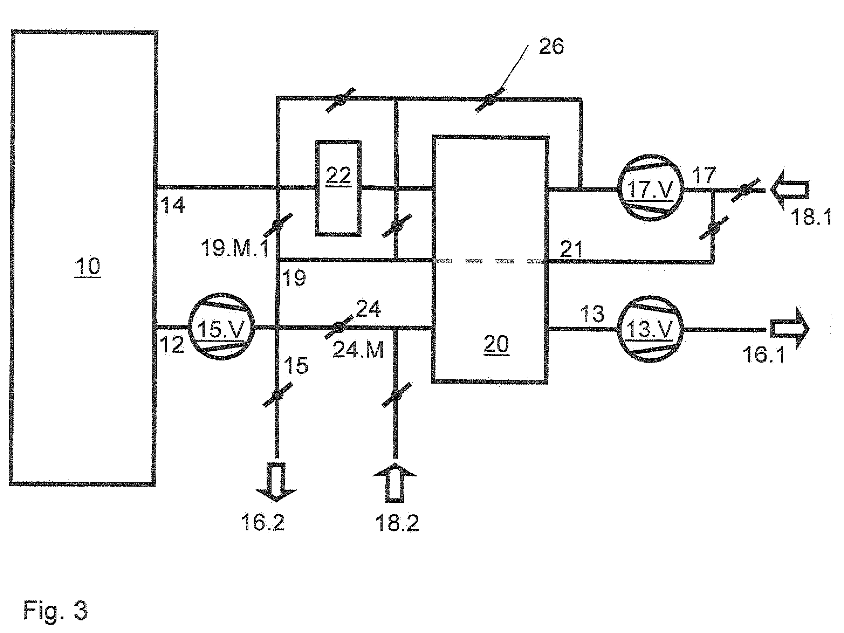

In den Figuren 1 bis 4 sind vier Ausführungsbeispiele erfindungsgemäßer raumlufttechnischer Geräte schematisch in ihrer Luftführung skizziert.

Jedes dieser vier raumlufttechnischen Geräte ist für die Kühlung eines Rechenzentrums 10 vorgesehen.

Grundsätzlich weisen sie auf: zumindest einen Abluft- 12, zumindest einen Zuluft- 14, zumindest zwei Fortluft- 16.1, 16.2 und zumindest zwei Außenluftanschluss/-anschlüsse 18.1, 18.2. Ein erster Hauptströmungsweg 17 ist zwischen dem Außenluftanschluss 18.1 und dem Zuluftanschluss 14 ausgebildet. Ein zweiter Hauptströmungsweg 15 verbindet den Abluftanschluss 12 mit einem der Fortluftanschlüsse 16.1, 16.2. In dem ersten 17 und dem zweiten Hauptströmungsweg 15 ist in den dargestellten Ausführungsbeispielen je ein einziger Ventilator 15.V, 17.V vorgesehen.

Eine Besonderheit der Erfindung liegt darin, dass gemäß allen vier Ausführungsbeispielen ein zweiter Außenluftanschluss 18.2, zumindest ein zweiter Fortluftanschluss 16.2 und zumindest ein dritter Hauptströmungsweg 13 mit einem dritten Ventilator 13.V vorgesehen sind. Dabei sind zumindest zwei der drei Hauptströmungswege 13, 15, 17 im Gegenstrom durch zumindest eine Wärmerückgewinnung 20 geleitet. In Hauptströmungsrichtung Richtung Rechenzentrum 10 ist der Wärmerückgewinnung 20 ein Kühlmodul 22 nachgeschaltet.

Gemäß den Ausführungsbeispielen der Figuren 1 bis 4 verbindet der dritte Hauptströmungsweg 13 einen der Fortluftanschlüsse 16.1 mit einem der Außenluftanschlüsse 18.2. In allen Ausführungsbeispielen ist ein einziger Verbindungsströmungsweg 19 den ersten und den zweiten Hauptströmungsweg 17, 15 miteinander verbindend schaltbar. Dazu ist beispielsweise eine Mischklappe 19.M.1 bekannter Art schaltbar.

Dabei leitet der einzige Verbindungsströmungsweg 19 bevorzugt ausschließlich einen Luftstrom vom zweiten 15 in den ersten Hauptströmungsweg 17.

Das Kühlmodul 22 ist bevorzugt als ein Hybridkühler ausgeführt, sodass der durchströmende Luftstrom nicht nur gekühlt sondern alternativ befeuchtet werden kann.

In einem Umluftbetriebszustand kann der Abluftanschluss 12 dem ersten Hauptströmungsweg 17 entgegen die Wärmerückgewinnung 20 umgehend 21 geführt mit dem ersten Hauptströmungsweg 17 verbunden werden, um mit der Außenluft zumindest teilweise gemischt zu werden.

Die Wärmerückgewinnung 20 ist bevorzugt als ein einteiliges Bauelement ausgeführt, nicht etwa als ein gekoppelter Wärmeübertrager in einem Kreislaufverbundsystem, sondern besonders bevorzugt als ein Plattenwärmeübertrager.

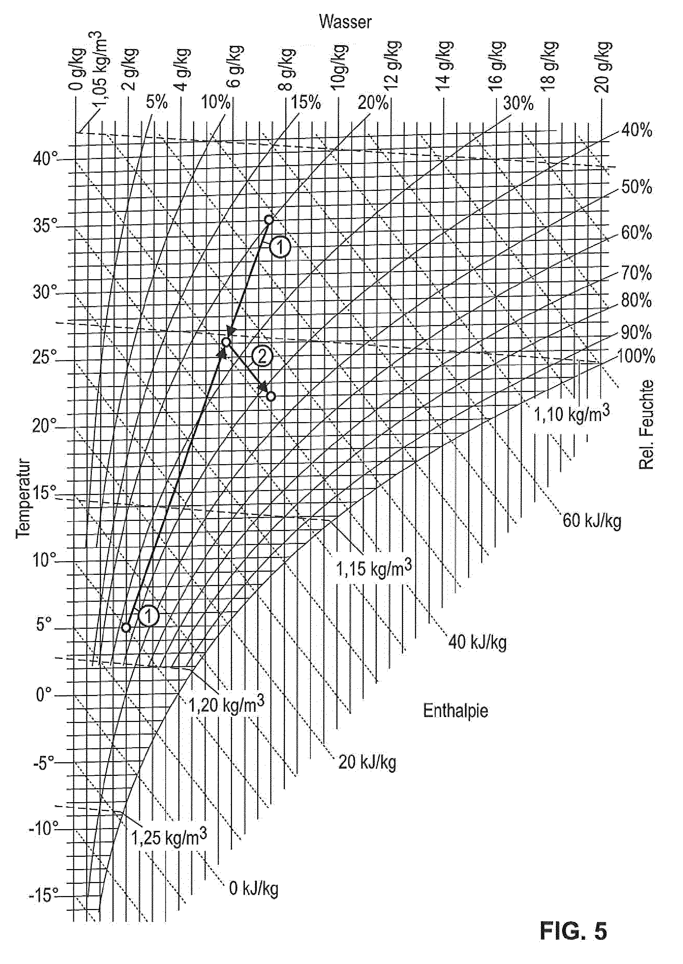

Auch das erfindungsgemäße Verfahren zum Kühlen des Rechenzentrums 10 lässt sich in den Figuren 1 bis 4 und auch in den Diagrammen der Figuren 5 bis 10 nachvollziehen. Zwei Hauptströmungswege 13, 15, 17 werden im Gegenstrom durch die Wärmerückgewinnung 20 geleitet. Zumindest der dritte Hauptströmungsweg 13 mit dem dritten Ventilator 13.V ist geschaltet, um die Wärmerückgewinnung mit der Zufuhr von Außenluft und / oder Abluft zu betreiben.

Dabei wird bevorzugt eines der vorangehend beschriebenen erfindungsgemäßen raumlufttechnischen Geräte verwendet.

Bevorzugt verbindet ein zweiter Verbindungsströmungsweg 24 den zweiten 15 und dritten Hauptströmungsweg 13 miteinander. Dabei beeinflusst eine weitere Mischklappe 24.M bekannter Art den Gehalt an Außenluft in dem durch die Wärmerückgewinnung 20 geleiteten Abluftstrom, indem sie den zweiten und dritten Hauptströmungsweg 13, 15 mehr oder weniger zueinander öffnet.

In einem Übergangsbetrieb kann die Zulufttemperatur mittels einer Leistungsregelung der Wärmerückgewinnung 20 geregelt werden, insbesondere auf etwa 20°C.

Ein Umluftanteil 21 kann gemäß einer vorteilhaften Ausführungsform des Verfahrens durch die Wärmerückgewinnung 20 geleitet werden, sodass die Eintrittsfeuchte vor der Luftbehandlung etwa 11 g/kg nicht überschreitet. Dazu wird die Eintrittsfeuchte an entsprechender Stelle gemessen und der Mischklappenregelung zugeführt.

In einem Außenluftbetrieb kann bevorzugt die Drehzahl zumindest eines der Ventilatoren 13.V, 15.V, 17.V zumindest in einer ersten Sequenz in Abhängigkeit der Rücklufttemperatur geregelt werden, insbesondere in einem Bereich zwischen 30 und 100 %.

In einem Außenluftbetrieb mit Mischbetrieb in einem Bereich etwa zwischen 4 g/kg und 10 g/kg Feuchte der Zuluft kann bevorzugt nach dem Prinzip der direkten freien Kühlung klimatisiert werden, wobei besonders bevorzugt in zweiter Sequenz Umluft beigemischt wird.

Beim Erreichen der maximalen direkten freien Kühlleistung und im Fall eines Überschreitens der Rückluft-Kühlgrenztemperatur über das Außenluftniveau wird bevorzugt die indirekte Verdunstungskühlung über Außenluft 18.2 des dritten Hauptströmungswegs 13 aktiviert, besonders bevorzugt indem die Abluft über den Fortluftventilator 15.V des zweiten Hauptströmungswegs 13 gefahren wird.

Der Fortluftventilator 13.V des dritten Hauptströmungsweges 13 wird bevorzugt analog zum Umluftanteil 19 in der Drehzahl geregelt, insbesondere mit dem Rückluftdruck oder Raumdruck des Rechenzentrums 10 als Führungsgröße.

Der Zuluftvolumenstrom 17, der über die Wärmerückgewinnung 20 und das Kühlmodul 22 gekühlt wird, kann bevorzugt um den Betrag der Mischluft 19 reduziert werden, der mittels der Mischklappe 19.M.1 geregelt wird.

In den Figuren 5 bis 10 sind oft in der Thermodynamik verwendete Mollier-h-x-Diagramme dargestellt, welche von links unten nach rechts oben verlaufende hyperbolische Linien gleicher relativer Feuchte in 5 bis 100 % - Linien über dem Temperatur-/Feuchte-Feld der Luft zeigen. Von links oben nach rechts unten verlaufen Geraden gleicher Enthalpie in 0 bis 60 kJ/kg - Linien über ebendiesem Feld. Linien gleicher Luftdichte verlaufen mit leichtem Gefälle von links nach rechts mit Angaben in der Einheit kg/m³.

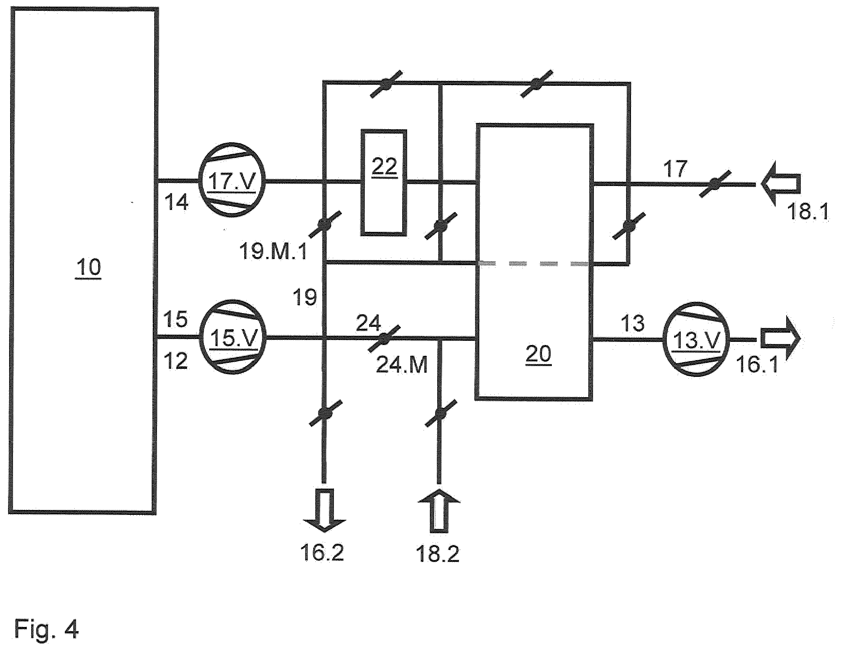

In Figur 5 ist ein Winterfall mit einem absoluten Luftfeuchtegehalt kleiner 4 g / kg mit Pfeilen eingetragen. So werden eine Abluft mit 35 °C und eine Außenluft mit 5 °C aus Zuständen 1 gemischt. Dies geschieht erfindungsgemäß bei Betrachtung der Figur 4, indem die Außenluft die Wärmeübertragung 20 vollständig umfährt und nach Beimischung von Abluft durch den Verbindungsströmungsweg 19 bei Öffnung der Mischklappe 19.M.1 gemeinsam leicht befeuchtet als Zuluft ins Rechenzentrum 10 gelangt. Das Befeuchten bei gleicher Enthalpie ist mit einem Pfeil 2 gekennzeichnet.

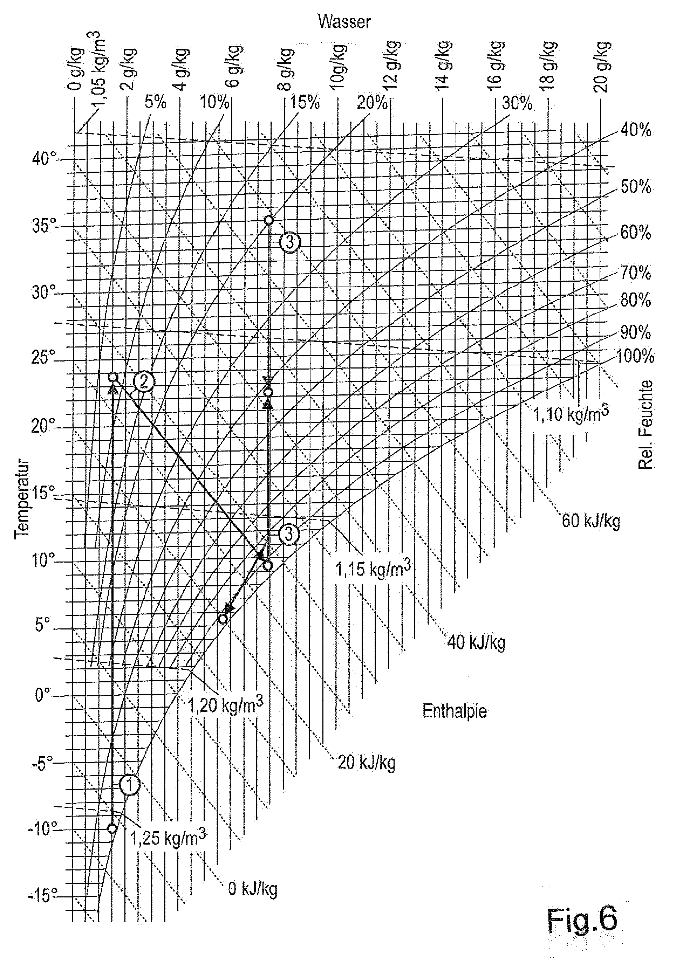

In Figur 6 ist ein alternativer Winterfall mit einem absoluten Luftfeuchtegehalt kleiner 4 g/kg dargestellt. So werden eine Abluft mit 35 °C und eine Außenluft mit -10 °C durch die Wärmerückgewinnung 20 gem. Figur 4 geführt. Die Außenluft des Außenluftanschlusses 18.1 wird nach diesem Ausführungsbeispiel eines erfindungsgemäßen Verfahrens vollständig durch die Wärmerückgewinnung 20 (Pfeil 1) gefahren und anschließend als Zuluft auf dem Weg zum Rechenzentrum 10 befeuchtet (Pfeil 2). Ihr wird jedoch nach der Befeuchtung und vor dem Eintritt in das Rechenzentrum 10 aus dem Verbindungsströmungsweg 19 ein Teilstrom der nach der Befeuchtung abgekühlten Abluft zur Nacherwärmung beigemischt. Die Abluft 12 wird nämlich bei geschlossenem Fortluftanschluss 16.2 durch den Verbindungsströmungsweg 24 durch die Wärmerückgewinnung 20 geleitet.

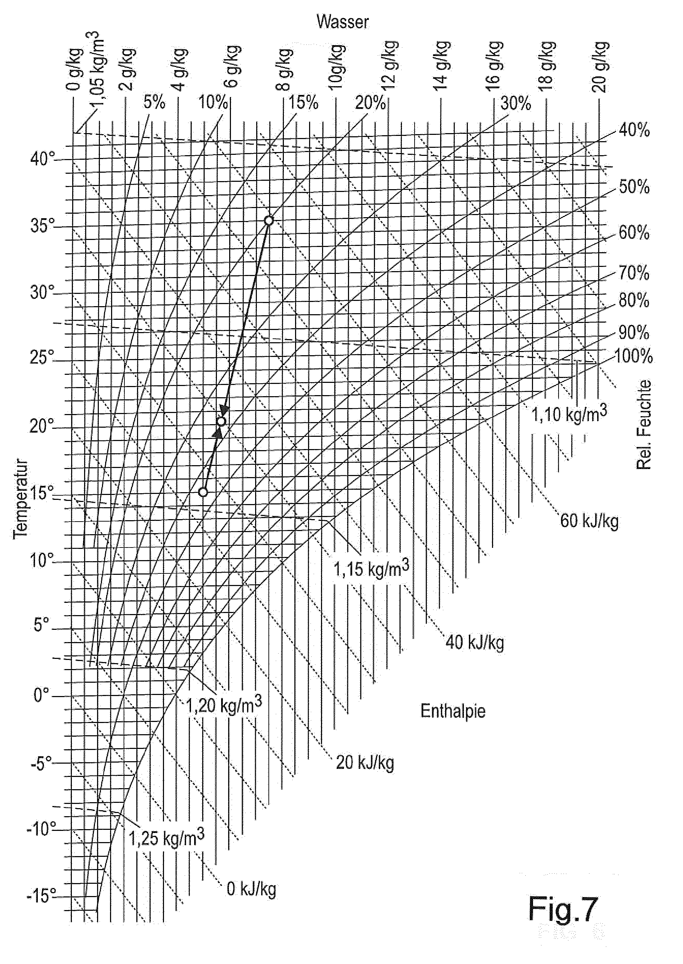

In Figur 7 ist ein Winterfall bei einer absoluten Feuchte x größer als 4 g/kg in das hx-Diagramm eingetragen. Hierbei muss in einem erfindungsgemäßen raumlufttechnischen Gerät nicht befeuchtet werden. Es kann eine Schaltung an der Wärmerückgewinnung 20 und an dem Kühlmodul 22 vorbei zur ausschließlichen Beimischung von Abluft aus dem Verbindungsströmungsweg 19 in die Zuluft genutzt werden. Es tritt in Folge eine etwas über 20 °C warme Luft mit leicht unter 40 % relativer Feuchte ins Rechenzentrum ein.

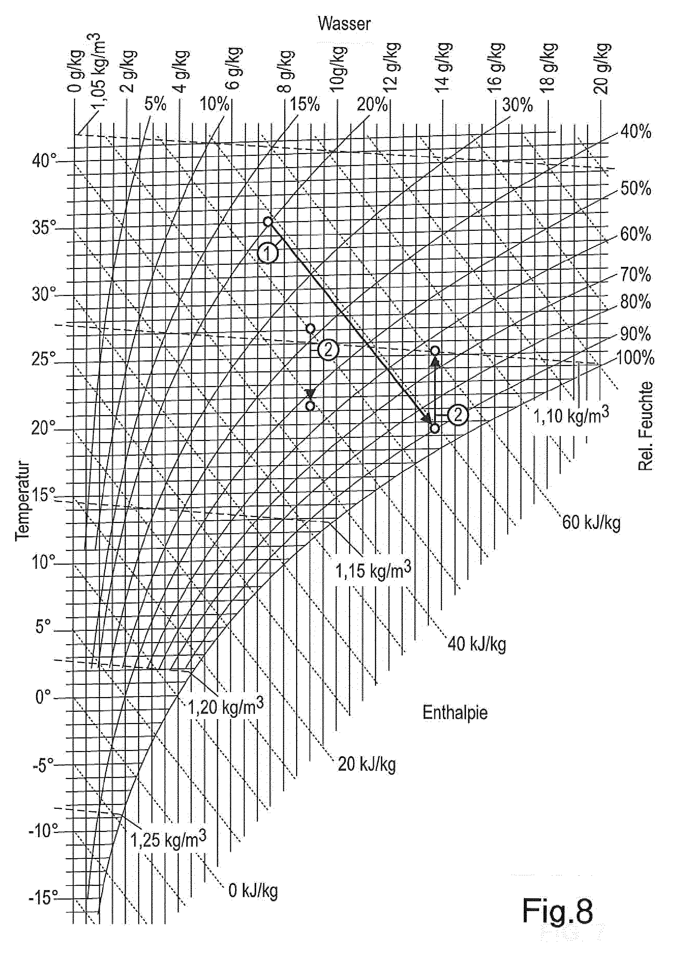

In Figur 8 ist ein Sommerfall bei absoluter Feuchte der Außenluft unter 10 g/kg gezeigt. Hierbei wird die Abluft des Rechenzentrums 10 bei geschlossenem Verbindungsströmungsweg 19 und Befeuchtung in die Wärmerückgewinnung 20 geführt, sodass in der Wärmeübertragung eine Verdunstungskälte zum Abkühlen der entgegenströmenden Außenluft nutzbar ist. Die Zustandsänderung der gekühlten Außenluft ist mit dem kleineren der beiden eingetragenen Pfeile, der von oben nach unten gerichtet ist, eingetragen. Die absolute Feuchte des Zuluftstroms ändert sich mithin nicht sondern bleibt konstant bei etwa 9 g/kg. Die relative Feuchte der Zuluft steigt im Zuge der Abkühlung um etwa 13 % auf etwa 52 % relative Feuchte.

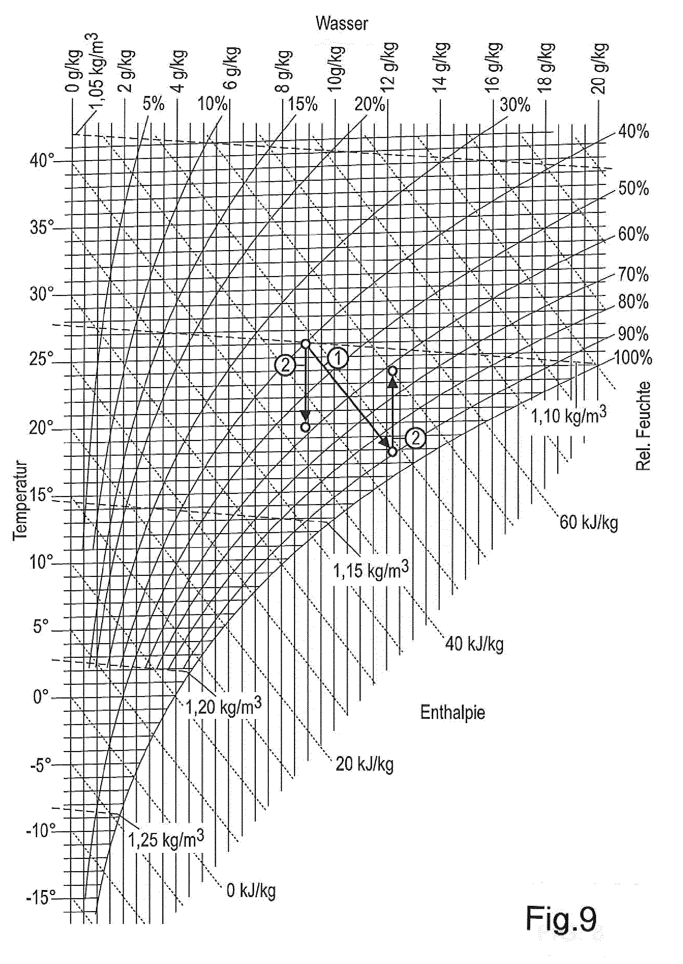

In Figur 9 ist ausgehend von einem ähnlichen Sommerfall, wie er der Schaltung gemäß Figur 8 zugrunde gelegen hat, mit etwa 10 g/kg eine alternative Schaltung in das hx-Diagramm eingetragen, wonach eine Kühlung in dem erfindungsgemäßen raumlufttechnischen Gerät auch rein mittels Außenluft erfolgen kann. Vollzieht man diese Verfahrensweise in Figur 4 nach, müssen sämtliche Verbindungsströmungswege 19, 24 geschlossen sein. Der Abluftventilator 15.V zieht sodann die Abluft aus dem Rechenzentrum 10 als eine erste Fortluft 16.2 ab. Durch den Zuluftventilator 17.V gelangt durch die Wärmerückgewinnung 20 geleitete Außenluft 18.1 an dem Kühlmodul 22 vorbei als Zuluft 14 in das Rechenzentrum 10, als ein kurzer vertikaler Pfeil von oben nach unten weisend in Fig. 9 eingetragen. Dieser Zuluft entgegen, als geknickter längerer Pfeil in Fig. 9 eingetragen, ist bei konstanter Enthalpie befeuchtete Außenluft 18.2 durch die Wärmerückgewinnung (vertikales Pfeilende von unten nach oben in Fig. 9) geleitet , um mit geminderter Enthalpie die Wärmeübertragung 20, getrieben mittels des Fortluftventilators 13.V als Fortluft 16.1 zu verlassen.

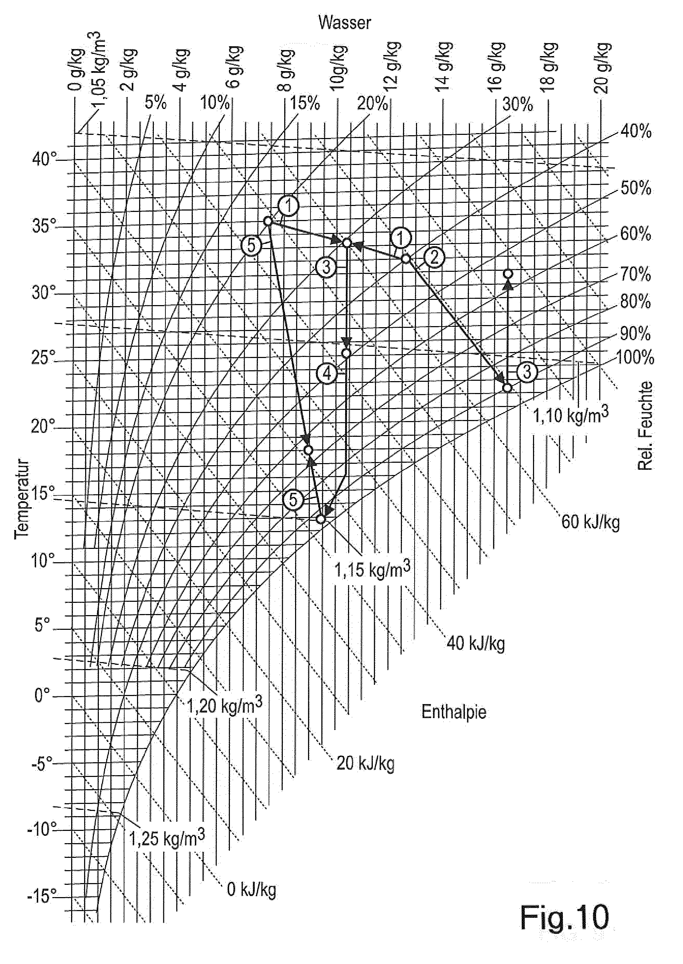

In einem Sommerfall bei höherer absoluter Feuchte in der Außenluft über 10 g/kg wird gemäß Figur 10 erfindungsgemäß bevorzugt mittels befeuchteter Außenluft 18.2 gekühlt 20. Dieser befeuchteten Außenluft wird in der Wärmeübertragung 20 Enthalpie genommen.

Die Abluft 12 aus dem Rechenzentrum 10 wird in einem Teilstrom als Fortluft 16. 2 abgeblasen. In einem weiteren Teilstrom gelangt Abluft mit 35 °C über den Verbindungsströmungsweg 19 wiederum geteilt in den ersten Hauptströmungsweg 17. Ein erster Teilabluftstrom wird gemäß in Figur 10 von links oben nach rechts unten verlaufender Pfeil 5 mit gekühlter Luft aus der Wärmerückgewinnung 20 mit nachgeschaltetem Kühlmodul 22 gemischt direkt als Zuluft 14 ins Rechenzentrum 10 geleitet. Ein zweiter Teilabluftstrom wird mit der in die Wärmerückgewinnung 20 einlaufenden Außenluft 18.1 gemischt, um gemeinsam in ihrer Enthalpie und ihrer Temperatur gemindert zu werden (Pfeile 3 und 4). Die beiden Teilabluftströme, welche durch den Verbindungsströmungsweg 19 gemeinsam bis zu ihrer vorübergehenden Trennung Richtung Zuluft 14 unterwegs waren, treten schließlich wieder vollständig vereint als Zuluft mit beispielsweise 18 °C und 65 % rel. Feuchte in das Rechenzentrum 10 ein. Weitere Außenluft 18.1 wurde dem zweiten Teilabluftstrom nach Figur 4 über den ersten Hauptströmungsweg 17 mit Außenluftanschluss 18.1 beigemischt. Die erfindungsgemäßen raumlufttechnischen Geräte lassen sich demnach in Abhängigkeit der Messung von absoluter Feuchte x in g/kg und Temperatur der Außenluft regeln.

### Bezugszeichenliste:

- 10: Rechenzentrum
- 12: Abluftanschluss
- 13: dritter Hauptströmungsweg
- 13.V: Ventilator
- 14: Zuluftanschluss
- 15: zweiter Hauptströmungsweg
- 15.V: Ventilator
- 16.1: Fortluftanschluss
- 16.2: Fortluftanschluss
- 17: erster Hauptströmungsweg
- 17.V: Ventilator
- 18.1: Außenluftanschluss
- 18.2: Außenluftanschluss
- 19: Verbindungsströmungsweg

- 20: Wärmerückgewinnung
- 21: separate Gegenstromführung
- 22: Kühlmodul
- 24: zweiter Verbindungsströmungsweg
- 24.M: zweite Mischklappe

## Patentansprüche

1. Raumlufttechnisches Gerät, insbesondere für die Kühlung eines Rechenzentrums (10), mit zumindest einem Abluft-(12), zumindest einem Zuluft- (14), zumindest einem Fortluft- (16.1, 16.2) und zumindest einem Außenluftanschluss (18.1, 18.2), mit einem ersten Hauptströmungsweg (17) zwischen dem zumindest einen Außenluftanschluss (18.1) und dem zumindest einen Zuluftanschluss (14) und einem zweiten Hauptströmungsweg (15) zwischen dem zumindest einen Abluftanschluss (12) und dem zumindest einen Fortluftanschluss (16.1, 16.2) und mit einem Kühlmodul (22), wobei in dem ersten (17) und dem zweiten Hauptströmungsweg (15) je ein Ventilator (15.V, 17.V) vorgesehen ist, wobei zumindest zwei Hauptströmungswege (13, 15, 17) im Gegenstrom durch zumindest eine Wärmerückgewinnung (20) geleitet sind **dadurch gekennzeichnet, dass** zwischen einem zweiten Außenluftanschluss (18.2) und einem zweiten Fortluftanschluss (16.2) ein dritter Hauptströmungsweg (13) mit einem dritten Ventilator (13.V) verläuft, wobei ein einziger Verbindungsströmungsweg (19) den ersten und den zweiten Hauptströmungsweg (17, 15) miteinander verbindend schaltbar ist und der einzige Verbindungsströmungsweg (19) ausschließlich einen Abluftstrom vom zweiten (15) in den ersten Hauptströmungsweg (17) zu leiten bestimmt ist.

2. Raumlufttechnisches Gerät nach Anspruch 1,
**dadurch gekennzeichnet, dass** das Kühlmodul (22) als Hybridkühler ausgeführt ist, sodass der durchströmende Luftstrom nicht nur gekühlt sondern alternativ befeuchtet werden kann.

3. Raumlufttechnisches Gerät nach einem der vorangehenden Ansprüche,
**dadurch gekennzeichnet, dass** in einem Umluftbetriebszustand der Abluftanschluss (12) dem ersten Hauptströmungsweg (17) entgegen (21) die Wärmerückgewinnung (20) umgehend geführt mit dem ersten Hauptströmungsweg (17) verbunden ist, um mit der Außenluft zumindest teilweise gemischt zu werden.

4. Raumlufttechnisches Gerät nach einem der vorangehenden Ansprüche,
**dadurch gekennzeichnet, dass** die Wärmerückgewinnung (20) als ein einteiliges Bauelement ausgeführt ist, nicht etwa als ein gekoppelter Wärmeübertrager (Kreislaufverbundsystem), sondern insbesondere als ein Plattenwärmeübertrager.

5. Verfahren zum Klimatisieren eines Rechenzentrums (10) mit zumindest drei Hauptströmungswegen (13, 15, 17) zwischen Abluft- (12), Zuluft- (14), Fortluft- (16.1, 16.2) und Außenluftanschlüssen (18.1, 18.2), wobei jeder Hauptströmungsweg (13, 15, 17) zumindest einen Ventilator (13.V, 15.V, 17.V) aufweist, ferner mit einem Kühlmodul (22), einer Wärmerückgewinnung (20) und einem Verbindungsströmungsweg (19) zum Verbinden zumindest zweier Hauptströmungswege (15, 17),
wobei
zwei Hauptströmungswege (13, 15, 17) im Gegenstrom durch die Wärmerückgewinnung (20) geleitet werden,
**dadurch gekennzeichnet, dass** zumindest der dritte Hauptströmungsweg (13) mit dem dritten Ventilator (13.V) geschaltet ist, um die Wärmerückgewinnung (20) mit der Zufuhr von Außenluft und / oder Abluft zu betreiben.

6. Verfahren nach Anspruch 5,
**dadurch gekennzeichnet, dass** ein Raumlufttechnisches Gerät nach einem der Ansprüche 1 bis 4 verwendet wird.

7. Verfahren nach einem der Ansprüche 5 oder 6,
**dadurch gekennzeichnet, dass** ein zweiter Verbindungsströmungsweg (24) den zweiten (15) und dritten Hauptströmungsweg (13) miteinander verbindet, wobei eine Mischklappe (24.M) den Gehalt an Außenluft in dem durch die Wärmerückgewinnung (20) geleiteten Abluftstrom beeinflusst, indem sie den zweiten und dritten Hauptströmungsweg (13, 15) mehr oder weniger zueinander öffnet.

8. Verfahren nach einem der Ansprüche 5 bis 7,
**dadurch gekennzeichnet, dass** in einem Übergangsbetrieb die Zulufttemperatur mittels der Leistungsregelung der Wärmerückgewinnung (20) geregelt wird, insbesondere auf etwa 20°C.

9. Verfahren nach Anspruch 8,
**dadurch gekennzeichnet, dass** ein Umluftanteil (21) durch die Wärmerückgewinnung (20) geleitet wird, sodass die Eintrittsfeuchte vor der Luftbehandlung etwa 11 g/kg nicht überschreitet.

10. Verfahren nach einem der Ansprüche 5 bis 9,
**dadurch gekennzeichnet, dass** in einem Außenluftbetrieb die Drehzahl zumindest eines der Ventilatoren (13.V, 15.V, 17.V) zumindest in einer ersten Sequenz in Abhängigkeit der Rücklufttemperatur geregelt wird, insbesondere in einem Bereich zwischen 30 und 100 %.

11. Verfahren nach einem der Ansprüche 5 bis 10,
**dadurch gekennzeichnet, dass** in einem Außenluftbetrieb mit Mischbetrieb ebenfalls in einem Bereich etwa zwischen 4 g/kg und 10 g/kg Feuchte der Zuluft nach dem Prinzip der direkten freien Kühlung klimatisiert wird, wobei bevorzugt in zweiter Sequenz Umluft beigemischt wird.

12. Verfahren nach einem der Ansprüche 5 bis 11,
**dadurch gekennzeichnet, dass** beim Erreichen der maximalen direkten freien Kühlleistung und im Fall eines Überschreitens der Rückluft-Kühlgrenztemperatur über das Außenluftniveau die indirekte Verdunstungskühlung über Außenluft (18.2) des dritten Hauptströmungswegs (13) aktiviert wird und indem die Abluft über den Fortluftventilator (15.V) des zweiten Hauptströmungswegs (13) gefahren wird.

13. Verfahren nach einem der Ansprüche 5 bis 12,
**dadurch gekennzeichnet, dass** der Fortluftventilator (13.V) des dritten Hauptströmungsweges (13) analog zum Umluftanteil (19) in der Drehzahl geregelt wird, insbesondere mit Führungsgröße Rückluftdruck oder Raumdruck des Rechenzentrums (10).

14. Verfahren nach einem der Ansprüche 5 bis 13,
**dadurch gekennzeichnet, dass** der Zuluftvolumenstrom (17), der über die Wärmerückgewinnung (20) und das Kühlmodul (22) gekühlt wird, um den Betrag der Mischluft (19) reduziert wird, der mittels einer weiteren Mischklappe (19.M.1) geregelt wird.
